(19) Europäisches Patentamt
European Patent Office
Office européen des brevets

(11) Veröffentlichungsnummer: **0 023 596**
**A1**

(12) # EUROPÄISCHE PATENTANMELDUNG

(21) Anmeldenummer: **80103913.2**

(22) Anmeldetag: **09.07.80**

(51) Int. Cl.³: **C 08 L 65/02**, H 01 B 1/12, H 01 L 29/28, H 01 L 31/02

(30) Priorität: **20.07.79 DE 2929366**

(43) Veröffentlichungstag der Anmeldung: **11.02.81 Patentblatt 81/6**

(84) Benannte Vertragsstaaten: **AT BE CH DE FR GB IT LI LU NL SE**

(71) Anmelder: **BASF Aktiengesellschaft, Carl-Bosch-Strasse 38, D-6700 Ludwigshafen (DE)**

(72) Erfinder: **Naarmann, Herbert, Dr., Haardtblick 15, D-6719 Wattenheim (DE)**
Erfinder: **Penzien, Klaus, Dr., Bensheimer Ring 18, D-6710 Frankenthal (DE)**
Erfinder: **Naegele, Dieter, Dr., Obere Jakobstrasse 8, D-6520 Worms 24 (DE)**

(54) **Verfahren zur Herstellung elektrisch leitfähiger Polyphenylene und deren Verwendung in der Elektrotechnik und zur antistatischen Ausrüstung von Kunststoffen.**

(57) Die Erfindung betrifft ein Verfahren zur Herstellung von elektrisch leitfähigen Polyphenylenen, wobei üblichen Polyphenylenen unter Ausschluss von Feuchtigkeit und von Sauerstoff mit 0,5 bis 5 Gewichtsprozent einer starken Lewis-Säure mit $pk_s$-Werten von −10 bis +4 zugesetzt werden. Als Lewis-Säuren kommen insbesondere die Verbindungen $AsF_5$, $SbF_5$, $HClO_4$, $NO^+SbF_6^-$, $NO_2^+SbF_6^-$, $NO^+SbF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-Trinitrophenol, 2,4,6-Trinitrophenylsulfosäure oder 2,4,6-Trinitrophenylcarbonsäure, in Betracht. Die erhaltenen Produkte können in der Elektrotechnik zur Herstellung von Sonnenzellen, zur Umwandlung und Fixierung von Strahlung und zur Herstellung elektrischer und magnetischer Schalter sowie zur antistatischen Ausrüstung von Kunststoffen verwendet werden.

EP 0 023 596 A1

ACTORUM AG

# Verfahren zur Herstellung elektrisch leitfähiger Polyphenylene und deren Verwendung in der Elektrotechnik und zur antistatischen Ausrüstung von Kunststoffen

Die Erfindung betrifft ein Verfahren zur Herstellung von elektrisch leitfähigen Polyphenylenen mit elektrischen Leitfähigkeitswerten größer als $10^{-2}$S/cm und deren Verwendung in der Elektroindustrie zur Herstellung von Sonnenzellen, zur Umwandlung und Fixierung von Strahlung und zur Herstellung elektrischer und magnetischer Schalter sowie zur antistatischen Ausrüstung von Kunststoffen.

Es ist bereits bekannt, Polyphenylene durch oxidative Kupplung entsprechend der Literatur: "Macromolecular Syntheses Collective", Vol. 1, (1979) Seiten 109 bis 110, Verlag John Wiley & Sons und "Naturwissenschaften" 56 (1969) Seiten 308 bis 313 herzustellen. Außerdem ist die Herstellung von Polyphenylenen durch stufenweise Polykondensation nach R. Gehm und W. Kern aus "Makromolekulare Chemie" 7 (1951) Seiten 46 bis 61 bekannt, wobei besonders einheitliche para-verkettete methylsubstituierte Derivate erhalten werden, die nicht zusätzlich durch ortho- oder meta-verknüpfte Polymere verunreinigt sind.

Der Erfindung lag die Aufgabe zugrunde, die an sich bekannten Polyphenylene durch Zusätze in elektrisch leitfähige Polymere mit elektrischen Leitfähigkeitswerten größer als $10^{-2}$S/cm umzuwandeln.

Diese Aufgabe wird erfindungsgemäß dadurch gelöst, daß man den Polyphenylenen unter Ausschluß von Wasserfeuchtigkeit und von Sauerstoff, 0,5 bis 5 Gewichtsprozent, bezogen auf das eingesetzte Polyphenylen, eine starke Lewis-Säure mit $pk_s$-Werten von -10 bis +4 zusetzt. Nach bevorzugter Verfah-

Fre/BL

rensweise wird als Lewis-Säure die Verbindung $AsF_5$, $SbF_5$, $HClO_4$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-Trinitrophenol, 2,4,6-Trinitrophenylsulfonsäure oder 2,4,6-Trinitrophenylcarbonsäure zugesetzt.

Unter Polyphenylenen werden höhermolekulare Produkte verstanden, deren Ketten vollständig aus aneinander gekoppelten, gegebenenfalls Substituierten R tragenden Phenylringen gemäß der allgemeinen Formel:

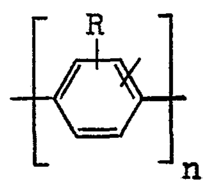

bestehen, und die durch dehydrierende Pyrolyse sowie andere Verfahren der Dehydrierung bzw. oxidativen Kupplung aus Benzol bzw. substituierten Benzolen erhalten werden. Bevorzugt sind Polyphenylene mit einer Verknüpfung der Phenylringe in para-Stellung. Die Polyphenylene weisen ein Molekulargewicht von 800 bis 5.000 auf, d.h. n = 10 bis 50. Die Herstellung der Polyphenylene kann nach der eingangs zitierten Literatur erfolgen.

Die elektrischen Leitfähigkeitswerte werden in S/cm bei 30°C gemessen, die Messung selbst erfolgt nach der Methode von F. Beck, Berichte Bunsengesellschaft, Physikalische Chemie 68 (1964) Seiten 558 bis 567. Die elektrischen Leitfähigkeitswerte der erfindungsgemäßen leitfähigen Polyphenyle ist größer als $10^{-2}$ S/cm.

Nach dem erfindungsgemäßen Verfahren wird den Polyphenylenen unter Ausschluß von Wasserfeuchtigkeit und von Sauerstoff 0,5 bis 5 Gewichtsprozent, bezogen auf das eingesetzte Polyphenylen, eine starke Lewis-Säure mit $pk_s$-Werten von -10 bis +4 zugesetzt.

Das Einarbeiten der Zusätze erfolgt unter Ausschluß von Feuchtigkeit (Wasser) sowie Sauerstoff (Luft), es wird daher vorzugsweise unter Edelgas-Argonatmosphäre gearbeitet. Gegebenenfalls werden Hilfsflüssigkeiten wie Tetrahydrofuran, Dimethoxyglykol, Nitromethan oder Methylenchlorid eingesetzt, die nach dem Einarbeiten bei Temperaturen unter $30^{o}C$ in Vakuum abgezogen werden.

Durch die genannten Zusätze können elektrische Leitfähigkeitsanstiege von einigen Größenordnungen erreicht werden. Die Ausgangsleitfähigkeiten der nach der oxydativen Kupplungsmethode hergestellten Polyphenyle betrugen ca. $10^{-12}$ bis $10^{-8}$S/cm. Die nach der stufenweisen Kondensation hergestellten Polyphenylene haben Ausgangsleitfähigkeiten von weniger als $10^{-12}$S/cm, liefern aber nach der Zugabe der erfindungsgemäßen Zusätze Leitfähigkeiten größer als $10^{-2}$S/cm.

Die erfindungsgemäß hergestellten elektrisch leitfähigen Polyphenylene mit elektrischen Leitfähigkeiten größer als $10^{-2}$S/cm sind zur antistatischen Ausrüstung von Kunststoffen, zur Herstellung von Sonnenzellen, zur Umwandlung und

Fixierung von Strahlung sowie zur Herstellung elektrischer und magnetischer Schalter geeignet. Durch die Zusätze der starken Lewis-Säure zum Polyphenylen entstehen sog. p-Leiter (vgl. J. Chem. Education, Vol. 46, Nr. 2, Seite 82 [1969]).

Die in den folgenden Beispielen genannten Teile sind Gewichtsteile. Die Angabe der Gliederzahl n (Kettenlänge der Polyphenylene) erfolgt durch Endgruppenanalyse über IR-Bestimmung des Verhältnisses der monofunktionellen Endgruppe

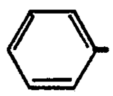 zur difunktionellen Mittelgruppe 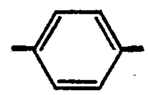.

Beispiele 1 bis 7

10 Teile eines Polyphenylens werden unter Argonatmosphäre und Ausschluß von Feuchtigkeit mit dem jeweiligen Zusatzstoff versetzt, die Messung der elektr. Leitfähigkeit erfolgt nach F. Beck. Ber. Bunsengesellschaft, Phys. Chem. 68, 558 - 567 1964.

| Nr. | Polyphenylen 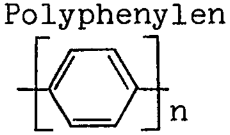 Typ und Menge | Zusatzstoff Art und Menge | Leitfähigkeit S/cm 30°C vor dem Zusatz | nach dem Zusatz |
|---|---|---|---|---|
| 1 | 10 Teile, n = ca. 25 | $AsF_5$ 0,1 | $10^{-13}$ | $3,8 \cdot 10^{-2}$ |
| 2 | 10 Teile, n = ca. 25 | $SbF_5$ 0,1 | $10^{-13}$ | $4,2 \cdot 10^{-2}$ |
| 3 | 10 Teile, n = ca. 25 | $HClO_4$ 0,1 | $10^{-13}$ | $3,2 \cdot 10^{-2}$ |
| 4 | 10 Teile, n = ca. 25 | $HClO_4$ 0,1 | | |
| 5 | 10 Teile, n = ca. 25+ | 2,4,6-Trinitrophenylsulfosäure | $10^{-13}$ | $8,7 \cdot 10^{-1}$ |
| 6 | 10 Teile, n = ca. 25+ | " | $10^{-13}$ | $6,8 \cdot 10^{-1}$ |
| 7 | 10 Teile, n = ca. 50 | $NO^+SbF_6^-$ 0,05 | $10^{-13}$ | $3,9 \cdot 10^{+1}$ |

+) bedeutet: nach der Methode R. Gehm und W. Kern, Makromolekulare Chemie 7 (1951) 46-61, hergestellt.

## Patentansprüche

1. Verfahren zur Herstellung von elektrisch leitfähigen Polyphenylenen mit elektrischen Leitfähigkeitswerten größer als $10^{-2}$ S/cm dadurch gekennzeichnet, daß den Polyphenylenen unter Ausschluß von Wasserfeuchtigkeit und von Sauerstoff 0,5 bis 5 Gewichtsprozent, bezogen auf das eingesetzte Polyphenylen, eine starke Lewis-Säure mit $pk_s$-Werten von -10 bis +4 zugesetzt wird.

2. Verfahren nach Anspruch 1, dadurch gekennzeichnet, daß als Lewis-Säure die Verbindung $AsF_5$, $SbF_5$, $HClO_4$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-Trinitrophenol, 2,4,6-Trinitrophenylsulfosäure oder 2,4,6-Trinitrophenylcarbonsäure zugesetzt wird.

3. Verwendung der nach Anspruch 1 hergestellten, leitfähigen Polyphenylene in der Elektrotechnik zur Herstellung von Sonnenzellen, zur Umwandlung und Fixierung von Strahlung und zur Herstellung elektrischer und magnetischer Schalter.

4. Verwendung der nach Anspruch 1 hergestellten leitfähigen Polyphenylene zur antistatischen Ausrüstung von Kunststoffen.

Europäisches Patentamt

# EUROPÄISCHER RECHERCHENBERICHT

0023596

Nummer der Anmeldung

EP 80 10 3913.2

| EINSCHLÄGIGE DOKUMENTE | | | KLASSIFIKATION DER ANMELDUNG (Int.Cl.3) |
|---|---|---|---|
| Kategorie | Kennzeichnung des Dokuments mit Angabe, soweit erforderlich, der maßgeblichen Teile | betrifft Anspruch | |
| E | EP - A1 - 0 016 305 (ALLIED CHEMICAL) * ganze Schrift * -- | 1-4 | C 08 L 65/02<br>H 01 B 1/12<br>H 01 L 29/28<br>H 01 L 31/02 |
| A | GB - A - 1 000 679 (BASF) * Seite 2, Zeilen 42 bis 46; Beispiele 1, 5 * -- | | |
| A | H. MEIER "Organic Semiconductors" 1974, VERLAG CHEMIE, Weinheim, Seite 234; Seiten 403 bis 418 * Seite 403, die letzten 3 Zeilen; Seite 404, Zeilen 1, 2; Seite 413, Absätze 6 bis 8; Seite 414, Absatz 1 * ---- | | |

RECHERCHIERTE SACHGEBIETE (Int. Cl.3)

C 08 G 61/00
C 08 K 3/00
C 08 L 65/00
H 01 B 1/00
H 01 L 29/00
H 01 L 31/00

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 10-11-1980 | KRAIL |